Europäisches Patentamt

European Patent Office

Office européen des brevets

(19)

(11) Veröffentlichungsnummer: **0 250 864**
**A2**

# (12) EUROPÄISCHE PATENTANMELDUNG

(21) Anmeldenummer: 87107610.5

(51) Int. Cl.⁴: **G01D 5/243**

(22) Anmeldetag: 25.05.87

(30) Priorität: 28.05.86 DE 3617941

(43) Veröffentlichungstag der Anmeldung:
07.01.88 Patentblatt 88/01

(84) Benannte Vertragsstaaten:
AT BE CH DE ES FR GB GR IT LI NL SE

(71) Anmelder: STILL GMBH
Berzeliusstrasse 10
D-2000 Hamburg 74(DE)

(72) Erfinder: Kröger, Thomas, Dipl.-Ing.
Blostwiete 1
D-2000 Hamburg 74(DE)
Erfinder: Fromme, Georg, Dr.-Ing.
Am Bach 23
D-2105 Seevetal 2(DE)
Erfinder: Suchanek, Joseph, Dipl.-Ing.
Kantstrasse 38
D-2o00 Hamburg 76(DE)

(74) Vertreter: Schaefer, Gerhard, Dr.
Linde Aktiengesellschaft Zentrale
Patentabteilung
D-8023 Höllriegelskreuth(DE)

(54) Induktiv arbeitende Sensoreinrichtung.

(57) Eine induktiv arbeitende Sensoreinrichtung dient der Erfassung von Größenänderungen bewegter Metallmassen, die sich in einem bestimmten Abstandsbereich zur sensorspule (I) eines Oszillators vorbeibewegen. Der Oszillatorausgang ist über eine Leitung (5) mit einer Auswerteeinrichtung (6) verbunden. Um für die Lage der Sensorspule (I) gegenüber der Metallmasse gewisse Maßungenauigkeiten zulassen zu können, wird vorgeschlagen, eine Zweigleitung (8) an die Oszillatorausgangsleitung (5) anzuschließen, die über ein Toleranzbandschaltung (9) an eine mit dem Oszillator verbundene Regeleinrichtung (II) angeschlossen ist. Bei Unter-oder Überschreitung einer vom Oszillator erzeugten Amplitudenhöhe wird von der Toleranzbandschaltung (9), deren Ausgangsleitung (I2) mit dem Oszillator verbunden ist, ein Einflußsignal auf die Regeleinrichtung (II) gegeben. Die Regeleinrichtung (II) sendet dann ein Regelsignal zum Oszillator, das die Oszillatoramplitude so verändert, daß die Amplitudenhöhe immer innerhalb einer vorgegebenen Toleranzbreite bleibt.

## Induktiv arbeitende Sensoreinrichtung

Die Erfindung betrifft eine Sensoreinrichtung gemäß Oberbegriff des Patentanspruchs I und ein Verfahren zum Betreiben einer solchen Einrichtung.

Zweck einer solchen Sensoreinrichtung ist in erster Linie, speziell geformte metallische Körper wie Zahnstangen oder Zahnräder oder mit in bestimmten Abständen versehenen Vorsprüngen versehene Scheiben abzutasten und aus der Anzahl bzw. den zeitlichen Abständen der festgestellten Änderungen der im Bereich der Sensoreinrichtung vorbeigeführten Metallmassen ein Signal für eine Geschwindigkeit, insbesondere für eine Drehzahl abzuleiten. Gegenstand der Erfindung ist somit ein auf induktiver Basis arbeitendes inkrementales Meßsystem, wobei ein Oszillator (Schwingkreis) durch Annäherung einer metallischen Masse bedämpft wird. Die Abmessungen der Erhebungen bzw. Vertiefungen des metallischen Körpers wie zum Beispiel die Breite und Länge der Zähne und die Länge und Tiefe der Nuten (Zahnzwischenräume) des Zahnrades bestimmen die maximale Größe der Sensorspule.

Für die digitale Drehzahlerfassung ist es bekannt, optische Markierungen zu verwenden, die mit optischen Sensoren zusammenwirken. Der Nachteil dieser Einrichtungen ist die große Empfindlichkeit gegen Verschmutzung. Verschmutzen die optischen Markierungen, bleiben die für das Erfassen des Geschwindigkeitswertes erforderlichen Signale aus. Es sind auch schon magnetische Markierungen und Einrichtungen zu deren Erfassung entwickelt worden. Auch hier besteht aber die Gefahr der Verschmutzung, beispielsweise durch festgesetzte Späne, die falsche Signale geben oder Signale unterdrücken.

Bekannt ist auch, eine Sensorspule als Bestandteil eines Oszillators zu verwenden und das Ausgangssignal des über die Sensorspule bedämpften Oszillators einer Auswertung zuzuleiten. Die bekannten Geräte arbeiten nur dann befriedigend, wenn die Sensorspule in einem ganz bestimmten Abstandsbereich gegenüber dem metallischen Körper, beispielsweise gegenüber den Spitzen der Zähne des Zahnrades angeordnet ist. Wird bei der Montage nicht mit hinreichender Genauigkeit der erforderliche Abstand eingehalten, sondern beispielsweise die Spule in einem etwas zu großen Abstand montiert, oder verändert sich während des Betriebes der Abstand der Spule von den Zahnspitzen infolge von Schwingungen, so ergeben sich keine für die Auswertung geeigneten Signale. Die Toleranzen sind meistens sehr eng.

Der Erfindung liegt die Aufgabe zugrunde, eine Sensoreinrichtung zu schaffen, die gegen Verschmutzung unempfindlich ist und bezüglich der Lage der Sensorspule gegenüber dem Metallkörper keine großen Anforderungen an Maßgenauigkeit stellt.

Diese Aufgabe wird durch eine Sensoreinrichtung mit den im Kennzeichen des Anspruchs I angegebenen Merkmalen gelöst und bzw. oder wird gelöst durch ein Verfahren mit den im Kennzeichen des Anspruchs angegebenen Merkmalen. Das Wesentliche der Erfindung liegt somit in der Amplitudenregelung des Oszillators. Die Amplitude des Oszillators kann innerhalb eines definierten Toleranzbandes durch einen metallischen Körper, beispielsweise den Zahn an einem Zahnrad, bedämpft werden. Verläßt der Spitzenwert der Oszillatorspannung das vorgegebene Toleranzband, tritt die gemäß der Erfindung vorgesehene Regeleinrichtung in Wirkung und verhindert ein übermäßiges Bedämpfen des Oszillators, das im Extremfall bis zur Unterbrechung des Schwingvorganges führen kann, bzw. verhindert eine Übersteuerung des Oszillators, die die Folge hätte, daß die Bedämpfung durch einen Metallkörper, beispielsweise den Zahn eines Zahnrades, nicht mehr ausgewertet werden kann. Durch die Erfindung wird somit beispielsweise der Aufbau eines Drehzahlgebers ermöglicht, der auch unter den durch Fertigung und Betrieb des Meßsystemes bedingten Einbautoleranzen noch zuverlässig funktionsfähig ist. Eine weitere Anwendungsmöglichkeit für den Gegenstand der Erfindung liegt in der Auswertung der Abhängigkeit der Ausgangsgröße des Reglers (Maß der Bedämpfung) vom Abstand der Sensorspule zum metallischen Körper.

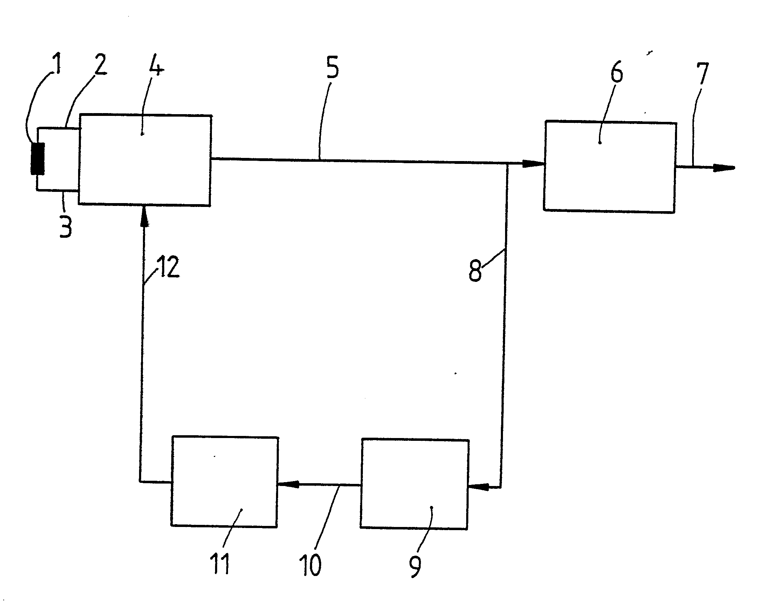

Im Folgenden wird der Gegenstand der Erfindung und seine Wirkungsweise und das Verfahren anhand des in der Zeichnung dargestellten Schaltschemas erläutert.

Die Sensorspule I ist über zwei Leitungen 2 und 3 mit dem übrigen Teil des Oszillators 4 verbunden. Von diesem aus führt eine Leitung 5 zu der Auswerteeinrichtung 6, von der aus eine Signalleitung 7 zu einer in der Zeichnung nicht mehr dargestellten Weiterverarbeitung (Mikroprozessor, Anzeigeeinrichtung) führt.

Der Oszillator erzeugt Spannungsschwingungen einer bestimmten Frequenz, die dann, wenn sich kein metallischer Körper in der Nähe der Sensorspule I befindet, eine bestimmte Amplitude haben. Diese Spannungsschwingungen werden über die Leitung 5 an die Auswerteeinrichtung 6 gegeben. Kommt ein Metallkörper, beispielsweise ein Zahn eines Zahnrades, in die Nähe

der Sensorspule I, so wird der Oszillator 4 gedämpft, so daß die Amplitude der durch die Leitung 5 weitergeleiteten Spannungsschwingungen verringert wird und entsprechend von der Auswerteeinrichtung 6 ein geändertes Signal über die Leitung 7 zur weiteren Verarbeitung weitergeleitet wird.

Soweit entspricht die Einrichtung dem bekannten Stand der Technik.

Gemäß der Erfindung ist an die Leitung 5 eine Leitung 8 angeschlossen, die zum Eingang einer Toleranzbandschaltung 9 führt, von der aus eine Leitung IO zu einer Regeleinrichtung II führt, die über die Leitung I2 wiederum mit dem Oszillator 4 verbunden ist.

Wird in der Toleranzbandeinrichtung 9 festgestellt, daß die Spannungsamplitude der in der Leitung 5 übertragenen Spannungsschwingungen das vorgegebene Toleranzband entweder nach oben über-oder nach unten unterschreitet, so gibt die Toleranzbandschaltung 9 über die Leitung IO ein Signal an die digitale Regeleinrichtung II, durch die in den Oszillator 4 über die Leitung I2 derart eingegriffen wird, daß die Amplitude der in der Leitung 5 übertragenen Spannung wieder innerhalb des vorgegebenen Toleranzbandes liegt. In der Auswerteeinrichtung 6 werden Signale ausgewertet, die durch die Anwesenheit eines metallischen Körpers an die Sensorspule I oder die Abwesenheit eines metallischen Körpers in der Nähe der Sensorspule I erzeugt werden und sich in einer Änderung der Amplitude der in der Leitung 5 geführten Spannungsschwingungen signalisieren, wobei infolge der Schaltung gemäß der Erfindung die in der Auswerteeinrichtung 6 auszuwertenden Spannungsamplituden immer im Rahmen eines gewissen Toleranzbandes liegen. Das heißt, die Schaltung 6 kann Oszillatorbe-bzw. -entdämpfungen verarbeiten innerhalb einer größeren Bandbreite, als die Bandbreite, auf die die Toleranzbandschaltung 9 ausgelegt ist, denn wird die Toleranzbandbreite, auf die die Toleranzbandschaltung 9 ausgelegt ist überschritten, wird sofort über die Regeleinrichtung II der Oszillator 4 gemäß der Erfindung nachgeregelt, so daß die der Auswerteeinrichtung 6 zugeführten Spannungsschwingungen Amplituden haben in einer Größenordnung, die die Auswerteeinrichtung 6 auswerten kann.

## Ansprüche

I. Induktiv arbeitende Sensoreinrichtung zum Erfassen von in die Nähe einer Sensorspule der Sensoreinrichtung bewegten Metallmassen, vorzugsweise der Änderung der Größe der in einem bestimmten Abstandbereich vorbeibewegten Metallmassen, mit einem mit der Sensorspule gebildeten Oszillator, dessen Ausgang über eine Verbindungsleitung mit einer ein Ausgangssignal liefernden Auswerteeinrichtung verbunden ist, dadurch gekennzeichnet, daß an die Oszillatorausgangsleitung (5) eine Zweigleitung (8) angeschlossen ist, die zu einer das Unterschreiten eines ersten Grenzwertes und das Überschreiten eines zweiten Grenzwertes der Oszillatorausgangsspannung erfassenden und bei Unterschreiten des ersten Grenzwertes oder bei Überschreiten des zweiten Grenzwertes ein Einflußsignal auf eine Regeleinrichtung (II) gebenden Toleranzbandschaltung (9) führt, deren Ausgangsleitung (I2) mit dem Oszillator derart verbunden ist, daß bei Vorhandensein eines Regelungssignals die maximale Spannungsspitze der Oszillatorspannung derart verändert wird, daß die Maximalwerte und Minimalwerte der Oszillatorausgangsspannung immer im Rahmen einer vorgegebenen Toleranzbandbreite liegen.

2. Verfahren zum Betrieb einer Sensoreinrichtung gemäß Anspruch I, dadurch gekennzeichnet daß die vom Oszillator (4) ausgehenden Schwingungen zusätzlich einer das Unterschreiten eines ersten Grenzwertes und das Uberschreiten eines zweiten Grenzwertes der Oszillatorausgangsspannung feststellenden Toleranzbandschaltung zugeführt werden, die bei Uberschreiten des ersten Grenzwertes bzw. Unterschreiten des zweiten Grenzwertes ein Einflußsignal auf eine Regeleinrichtung (II) gibt, die derart auf den Oszillator (4) einwirkt, daß bei Vorhandensein eines Regelungssignales der Regeleinrichtung (II) die maximalen Spannungsspitzen der Oszillatorspannung des Oszillators (4) derart verändert werden, daß die Maximalwerte und Minimalwerte der Oszillatorausgangsspannung im Rahmen einer vorgegebenen Toleranzbandbreite liegen.